# EUROPEAN PATENT APPLICATION

(11) **EP 4 002 815 A1**
(43) Date of publication of application: **25.05.2022**
(21) Application number: 19937765.6
(22) Date of filing: 14.11.2019
(51) Int. Cl.: H04M 1/04, F16M 13/00, F16M 11/38, F16M 11/00, H05K 7/18

(54) **FOLDABLE STAND**

(30) Priority: 18.07.2019 UA 201908513 U
(71) Applicant: Yushtin, Mikhail Yuryevich, Kharkiv, 61204 (UA)
(72) Inventor: Yushtin, Mikhail Yuryevich, Kharkiv, 61204 (UA)
(74) Representative: Perani & Partners S.p.A.
(86) International application number: PCT/UA2019/000142
(87) International publication number: WO 2021/010928

(57) **Abstract**

A foldable stand comprises a base (1) for receiving a mobile telephone (2), said base consisting of a middle part and two side parts, which are parallel to one another and are bendable, a means for securing a support element (3), said means being in the form of slots arranged symmetrically on the side parts at an angle to the edges thereof, and a means for retaining a mobile telephone, said means being configured in the form of cutouts arranged symmetrically at the front ends of the side parts.

## Description

### Technical field.

The invention relates to articles of a special format, which consist of several parts, and can be used as a support for portable electronic devices, in particular, mobile phones, to increase the level of comfort when using these electronic devices.

### Prior art.

With the distribution of portable electronic devices such as mobile phones, smartphones, tablet PCs, personal digital assistants, etc., and the inclusion of more and more functions in these devices, there is a growing demand for how these devices can be used while them on a table or other flat surface to be able to view information on the device's screen, leaving the user's hands free. When viewing information for a long time or during direct work with the device, inconveniences may arise in the placement of such devices and the rational use of the workplace.

To solve this problem, multifunctional foldable stands are increasingly used, allowing more convenient use of mobile electronic devices, and at the same time are used as an advertising medium.

The known foldable stand is made in the form of a rectangular card, which turns into a stand for mobile phones (patent US9308767B1). The stand is in the form of a credit or business card, which has cut lines and fold lines along which it can be folded into a stand so that portable electronic devices can be safely supported on the stand. Thus, advertising information or indicators of business information remain visible and are read by the user at the stands.

The disadvantages of such a stand are insufficient advertising space, small contact area with the surface and insufficient stability.

The known foldable stand is transformable from a rectangular sheet of rigid material having the size of a credit card. It contains a base, a support element, and has cut lines and fold lines along which it can be transformed into a stand for supporting portable electronic devices. (Patent US2010213331A1).

The disadvantage of such a stand is the lack of ease of manufacture and transformation. In addition, such a stand is not convenient enough to be used during presentations and simultaneously used as an advertising stand. Another drawback is the lack of convenience for placing the phone in landscape orientation.

### Disclosure of the invention.

The basis of the invention is to develop a foldable stand, in which, by changing the design, to create a more functional stand, which is easier to manufacture and transform, which will be convenient for use during presentations and will provide the possibility of its simultaneous use as a stand for a mobile phone and an advertising carrier, business or identification information.

The problem is solved by the fact that in a foldable stand, which contains a base for placing a mobile phone, a means for holding a phone made on it, a support element, a means for fixing a support element, and the opposite side ends of the base are parallel to each other and made elongated. In accordance with the invention, the base and the supporting element are made in the form of separate parts. The base contains a central and two lateral parts located in parallel and made with the possibility of bending. The lateral parts have bendable connections with the central part. The means for fixing the support element is made in the form of grooves located on the side parts symmetrically at an angle relative to the ends, and the means for holding the mobile phone is made in the form of cutouts located symmetrically on the front edges of the side parts.

According to one embodiment of the invention, the cutouts of the mobile phone holding means are rounded.

On the side parts, at least one more row of grooves is additionally made, located symmetrically at an angle relative to the ends.

The angle of the grooves is 30 ° - 60 °, and mainly 45 ° relative to the ends.

The supporting element is made in the form of an advertising, business or identification information carrier.

Thanks to the use of the stand of the above design, a large contact area with a horizontal surface is provided and, accordingly, greater stability. It is also achieved greater convenience of using a mobile phone, both horizontally and vertically, as well as using one hand; provided a large advertising space and the possibility of a longer storage of advertising, business or identification information. By increasing the advertising space, the stand can perform an additional function of an information carrier. This design allows the stand to be conveniently transformed into a compact, folded shape the size of a credit card, making the stand easy to carry with you. In addition, the stand of this design is easier to manufacture.

The execution of an additional row of grooves on the side parts allows you to adjust the angle of the mobile phone or use additional grooves to place an advertising, business or identification information-carrying medium, for example, a business card.

The angle of the grooves is 30 ° - 60 °, and mainly 45 ° relative to the ends, is the most convenient both for viewing the information placed on the supporting element and for viewing information from the screen of the mobile device.

The implementation of the supporting element in the form of an advertising, business or identification information carrier allows the product to be used simultaneously as a support and as a carrier of information, which is fully visible from an angle convenient for viewing.

### Brief description of the drawings.

The invention is illustrated by drawings, which show:
- FIG. 1-: assembled stand.
- FIG. 2 -: deployed base of the stand.
- FIG. 3 -: supporting element.
- FIG. 4 -: general view of the assembled stand.
- FIG. 5 -: general view of the assembled stand with an advertising, business or identification information carrier.

### Embodiments of the invention.

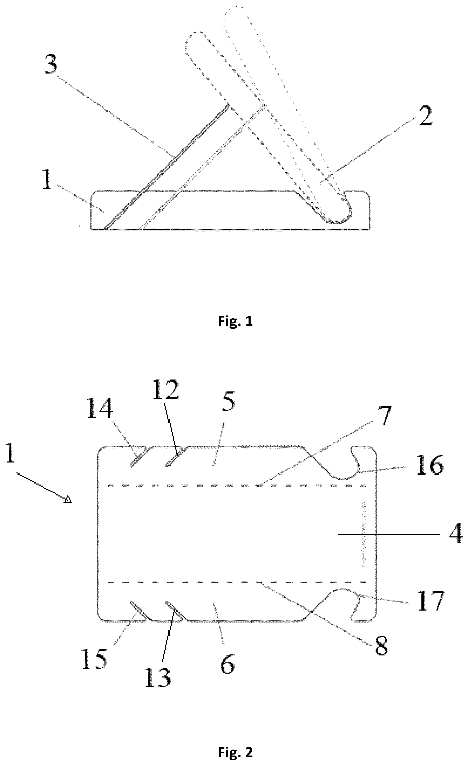

Shown in FIG. 1, the foldable stand contains a base 1 for placing a mobile phone 2 on it and a supporting element 3 for supporting a phone 2. The base 1 and the supporting element 3 are made in separate parts.

FIG. 2 shows a deployed base 1, from which the essence of the proposed invention becomes clear in detail. The base 1 contains a central part 4 and side parts 5 and 6, having bendable joints 7 and 8 with the central part 4, and can be folded relative to the central part along the lines of these joints. On the side parts 5 and 6, grooves 12 and 13 are symmetrically made at an angle relative to the ends for installing the supporting element 3. On these side parts, a second row of grooves 14 and 15 can be made to change the angle of the phone on the assembled stand or for placement in them business cards and other advertising, business or identification information-carrying medium. Cutouts 16 and 17 are also symmetrically made at the front edges of the side portions 5 and 6 to accommodate a mobile phone in an assembled stand.

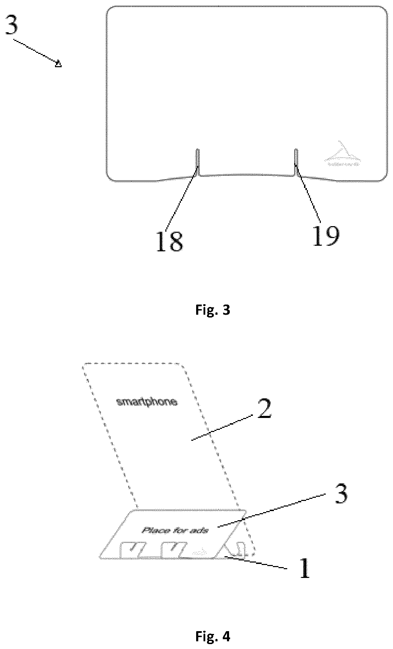

FIG. 3 shows a support element 3, which contains grooves 18, 19 for fixing the support element to the base.

FIG. 4 shows an assembled stand, in which the supporting element 3 is made in the form of an advertising, business or identification information carrier.

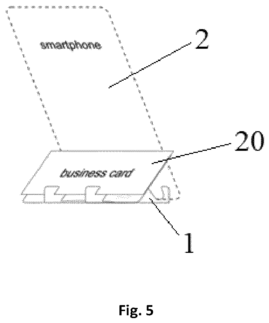

FIG. 5 shows an assembled stand, in which a business card 20 or other advertising, business or identification information carrier is placed in the grooves 14, 15

The stand is made as follows. A stand in the form of a deployed base with corresponding grooves, cutouts and fold lines and a support element are made separately. To use the stand, parts 5 and 6 are bent along the bendable joints 7 and 8 to a position practically perpendicular to the central part 4 and the support element 3 is inserted into the grooves 12 and 13. The cutouts 16 and 17 of the assembled base form a means for holding the mobile phone from moving along the axis of the base.

Flexible joints 7 and 8 can be equivalently made in the form of elastic or hinged, as well as other joints that provide the ability to rotate one surface relative to another.

The stand converts comfortably into a compact, folded form with the size of a credit card.

### Industrial applicability.

The stand can be used to support mobile phones and other portable electronic devices such as smartphones, tablet PCs, personal digital assistants, and the like.

The stand can be made of plastic, cardboard or other rigid material with simple technological equipment.

The invention, which is proposed, makes it possible to simplify the design of the stand, as well as to reduce its material consumption and labor intensity of manufacture.

## Claims

1. A foldable stand, which contains a base for placing a mobile phone, a means for holding a phone made on it, a support element, a means for fixing a support element, wherein the opposite side ends of the base are parallel to each other and made elongated, **characterized in that** the base and the support element are made in the form of separate parts, the base and the supporting element are made in the form of separate parts, the base contains a central and two lateral parts located in parallel and made with the possibility of bending, which have bendable connections with the central part, wherein the means for fixing the support element is made in the form of grooves located on the side parts symmetrically at an angle relative to the ends, and the means for holding the mobile phone is made in the form of cutouts located symmetrically on the front edges of the side parts.

2. The stand according to claim 1, **characterized in that** the cutouts of the means for holding the mobile phone are rounded

3. A stand according to claim 1 or 2, **characterized in that** at least one more row of grooves is additionally made on the side parts, located symmetrically at an angle relative to the ends.

4. The stand according to claim 1, 2 or 3, **characterized in that** the angle of the grooves is 30 ° - 60 °, and mainly 45 ° relative to the ends

5. The stand according to claim 1, 2, 3 or 4, **characterized in that** the support element is made in the form of an advertising, business or identification information carrier.
